# EUROPEAN PATENT APPLICATION

(11) **EP 4 456 427 A1**
(43) Date of publication of application: **30.10.2024**
(21) Application number: 24170753.8
(22) Date of filing: 17.04.2024
(51) Int. Cl.: H03K 17/96

(54) **TOUCH CONTROL PANEL AND HOUSHOLD APPLIANCE**

(30) Priority: 26.04.2023 CN 202320984137 U
(71) Applicant: BSH Hausgeräte GmbH, 81739 München (DE)
(72) Inventor: Zou, Qingqiang, Nanjing, 211101 (CN); Zang, Ming, Nanjing, 210046 (CN); Bai, Xuemei, Nanjing, 210046 (CN); Li, Jun, Nanjing city, 210000 (CN)

(57) **Abstract**

The present invention relates to a touch control panel and a home appliance thereof are provided. The touch control panel includes a front cover plate and a touch control module. A support is provided with positioning portions corresponding to touch key regions. Isolation members are arranged on the positioning portions. Elastic conductors at least partially extend into the positioning portions and abut against inner surfaces of the isolation members, so that outer surfaces of the isolation members abut against the front cover plate to limit the isolation members to the positioning portions. In the foregoing solution, an additional isolation member structure is added between the elastic conductors and the front cover plate, and a stroke and a position thereof are limited by using the support, so that the fitted structure is more stable. In addition, it is ensured that the isolation members can be maintained in close contact with the elastic conductors and the front cover plate, without affecting the touch sensitivity.

## Description

The invention relates to the technical field of home appliances, and in particular, to a touch control panel and a home appliance thereof or household appliance.

As technologies develop, a touch technology is used on increasing home appliances to realize human-machine interaction.

In the prior art, a capacitive touch sensing technology may be used to operate and control home appliances. An implementation of the capacitive touch sensing technology is to use a spring as a capacitive trigger medium. When a user touches a corresponding button or icon on a touch control panel, the spring can detect the touch operation signal of the user on the touch control panel, thereby controlling a home appliance based on the operation signal.

In the touch sensing solution using a spring, one end of the spring is usually arranged on a circuit board, and an other end is oriented toward and is in contact with a front cover plate. Since the spring is a conductor, which may result in a safety risk, to meet safety requirements, an isolation structure is usually arranged between the spring and the front cover plate to isolate the circuit board.

In the prior art, common manners of realizing an isolation structure include wrapping a spring with a plastic member, embedding a plastic member into a center of a spring, and the like. However, the prior art does not take fitting stability of the plastic member and the spring into consideration, which leads to foreseeable risks. For example, the plastic member is separated from the spring and malfunctions, or a fitting risk of the spring and the plastic part is increased during fitting of the touch control panel.

An object of the present invention is to provide an improved touch control panel and a household appliance.

A touch control panel according to an aspect of the present invention includes: a front cover plate, provided with a main body portion, where the main body portion is provided with touch key regions; and a touch control module, including a circuit module and a support located between the front cover plate and the circuit module, where a side of the circuit module close to the front cover plate is provided with elastic conductors, and the elastic conductors correspond to the touch key regions. The touch control module further includes isolation members. The support is provided with positioning portions corresponding to the touch key regions. The isolation members are arranged on the positioning portions. The elastic conductors at least partially extend into the positioning portions and abut against inner surfaces of the isolation members, so that outer surfaces of the isolation members abut against the front cover plate to limit the isolation members to the positioning portions.

In the foregoing solution, an additional isolation member structure is added between the elastic conductors and the front cover plate, and a stroke and a position thereof are limited by using the support, so that the fitted structure is more stable. In addition, it is ensured that the isolation members can be maintained in close contact with the elastic conductors and the front cover plate, without affecting the touch sensitivity.

In a possible embodiment, the positioning portions are of a through hole structure formed on the support. The through hole structure is provided on the touch control module, the isolation members are embedded therein in a free state, and the isolation members are limited to the support through an elastic compression force of the elastic conductors.

In a possible embodiment, the isolation members are movably arranged on the positioning portions in a direction perpendicular to a front cover plate. In this way, the isolation members not only can be limited to the front cover plate and the support without separation, but also can elastically expand and contract in an axial direction of the positioning portions within a specific range.

In a possible embodiment, the isolation members include limiting portions. When the circuit module is fitted to the support, the limiting portions abut against edges of the positioning portions under an action of the elastic conductors. Through the limiting portions and the positioning portions, the isolation members can be limited to the support without separation from the support.

In a possible embodiment, the isolation members further include walls extending in an axial direction of the elastic conductors, and the limiting portions extend radially outwards from the walls. Preferably, the isolation members are formed in the shape of a hat, and the limiting portions are of a brim structure extending radially outwards from edges of the isolation members. The structure in the shapes of the hat and the brim not only facilitates integral formation, but also facilitates setting of a position and an expansion and contraction stroke of the isolation members at the positioning portions.

In a possible embodiment, the limiting portions include a plurality of protrusions, and the protrusions are distributed on the walls.

In a possible embodiment, the support includes a surface facing the front cover plate. After the circuit module is fitted to the support, the isolation members at least partially extend out of the surface by a specific height under an action of the elastic conductors. In this way, the isolation members can have a specific expansion and extraction stroke. Therefore, when the touch control module is subsequently fitted to the front cover plate, the isolation members can be maintained in close contact with the front cover plate, without affecting detection sensitivity of a touch key. In addition, the isolation members do not generate an excessive force that damages the front cover plate. Preferably, the height is 2 mm.

In a possible embodiment, gaps are formed radially between the isolation members and the positioning portions, to ensure that the isolation members can move flexibly, and prevent problems that lead to poor contact such as jamming and tilting.

In a possible embodiment, a thickness of the isolation members in an axial direction is in a range of 0.7 mm to 1.0 mm. This embodiment can meet strength requirements on the isolation members while ensuring that a corresponding touch signal can be detected by the touch key.

In a possible embodiment, the isolation members are made of plastic. Because the plastic material is softer than a metal member, the plastic material can abut against the front cover plate desirably without scratching and wearing the front cover plate, thereby avoiding impact on an appearance of the touch control panel.

In a possible embodiment, the touch control module further includes a display film. The support includes light guide portions. The display film is arranged on a side of the support close to a front cover plate and covers the light guide portions.

In a possible embodiment, the touch control panel further includes a supporting portion. The touch control module is arranged on the supporting portion.

The present invention further discloses a home appliance, including the foregoing touch control panel. An additional isolation member structure is added between the elastic conductors and the front cover plate, and a stroke and a position thereof are limited by using the support, to ensure that the isolation members can keep close contact, ensure touch sensitivity of the touch control panel, and improve user experience of the home appliance or household appliance.
FIG. 1 is a schematic exploded view of a touch control panel according to an embodiment of the present invention.
FIG. 2 is a front view of the touch control panel in FIG. 1.
FIG. 3 and FIG. 4 are respectively a sectional view of the touch control panel taken along a line A-A in FIG. 2 and an enlarged view of a part B.
FIG. 5 is a schematic exploded view of a touch control module according to an embodiment of the present invention.
FIG. 6 is a front view of the touch control module in FIG. 5.
FIG. 7 and FIG. 8 are respectively a sectional view of the touch control module taken along a line C-C in FIG. 6 and an enlarged view of a part D.

A home appliance is usually provided with a human-machine interaction component, such as a touch control panel. A user may control an operation of the home appliance or household appliance by using the touch control panel.

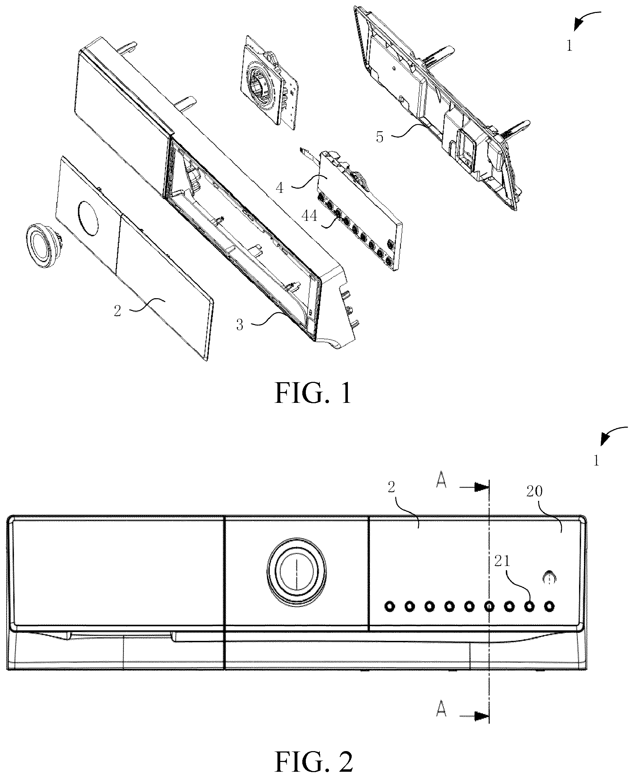

FIG. 1 is an exploded view of components of a touch control panel 1. FIG. 2 is a front view of the components of the touch control panel 1 after fitting. As shown in FIG. 1, the touch control panel 1 includes a front cover plate 2, a supporting portion 3, and a touch control module 4. An opening is provided on the supporting portion 3. The touch control module 4 is arranged at the opening of the supporting portion 3 and abuts against the front cover plate 2.

The touch control panel 1 further includes a rear cover plate 5, which may be connected to the supporting portion 3 and can abut against the touch control module 4, so that a side of the touch control module 4 facing the front cover plate 2 is more snugly attached to the front cover plate.

The front cover plate 2, the touch control module 4, and the rear cover plate 5 may be arranged on the supporting portion 3, and then the assembly of the components may be fitted to the home appliance as a whole.

As shown in FIG. 2, the front cover plate 2 is provided with a main body portion 20. The main body portion 20 is provided with touch key regions 21. A user may perform operations by touching indicator patterns corresponding to the touch key regions 21 or by touching corresponding touch keys 44. Functions of the touch keys 44 are implemented by using the touch control module 4.

In an embodiment, the front cover plate 2 may be made of glass or plastic. Preferably, a pattern of the touch key regions 21 may be provided on a side of the front cover plate 2 facing the touch control module 4, to prevent the pattern being worn after long-term use.

As shown in FIG. 1, the touch control module 4 may be provided with the touch keys 44, which are configured to detect a touch of a user. The touch control module 4 may be further provided with a display assembly, which is configured to display content of an interface of the touch control panel, and may be further configured to display corresponding content based on a detected signal indicating that the touch keys 44 are operated.

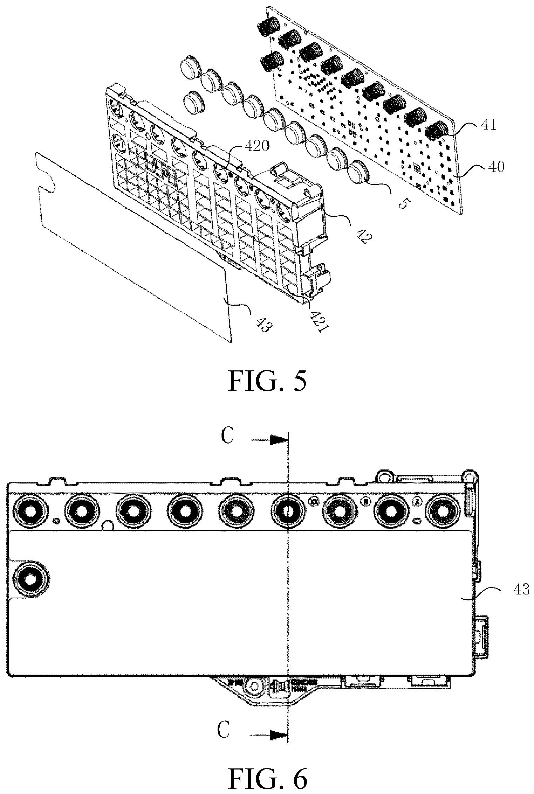

Specifically, FIG. 5 is an exploded view of the touch control module 4. In a stacking order of the components, the touch control module 4 sequentially includes a circuit module 40, a support 42, and a display film 43 from rear to front. The circuit module 40 and the display film 43 are respectively arranged on two sides of the support 42. The support 42 includes light guide portions 421. The display film 43 is arranged on the support 42 and covers the light guide portions 421.

In some embodiments, the circuit module 40 may be provided with lighting lamps such as LED lights to realize backlight. Positions on the support corresponding to the lighting lamps are provided with the light guide portions 421, so that light can be irradiated to the display film 43 through the light guide portions 421.

In some embodiments, the circuit module 40 may be further provided with elastic conductors 41. The elastic conductors 41 can abut against the front cover plate 2, and are in a one-to-one correspondence with the touch key regions 21. A quantity of the elastic conductors 41 may be set according to a quantity of required touch keys.

Generally, the elastic conductors 41 may be springs or elastic pieces of a specific shape.

In an embodiment, the touch control module 4 further includes isolation members 5. Generally, the isolation members 5 are arranged between the elastic conductors 41 and the front cover plate 2, to isolate a non-safety extra-low voltage, that is, the circuit module 40, to meet a safety requirement. The isolation members are generally made of plastic.

Specifically, according to relevant regulations in the "General Safety Standards for Home Appliances", components in contact with an electrified component need to pass a ball pressure test. However, the front cover plate 2 usually cannot meet the requirement. Therefore, the isolation members 5 are arranged between the elastic conductors 41 and the front cover plate 2, to prevent the front cover plate 2 from failing the ball pressure test. In addition, since plastic is softer than metal and has a smooth surface, the front cover plate can be protected, thereby preventing the front cover plate from being scratched and preventing an appearance of the touch control panel from being affected during fitting.

In an embodiment, the support 42 is configured with positioning portions 420. Arrangement positions of the positioning portions 420 may correspond to the touch key regions 21 of the front cover plate 2. For example, the positioning portions 420 may be a hole structure on the support 42.

In an embodiment, for fitting convenience of the isolation members 5 and stability of the isolation members after fitting, the isolation members 5 may be arranged on the positioning portions 420 of the support 42, and ends of the elastic conductors 41 abut against the isolation members 5. The isolation members 5 are provided with limiting portions 51, so that the isolation members 5 can be limited to the positioning portions 420. In addition, the isolation members 5 are embedded in the support 42 of the touch control module 4, to facilitate subsequent transportation and fitting of the touch control module 4.

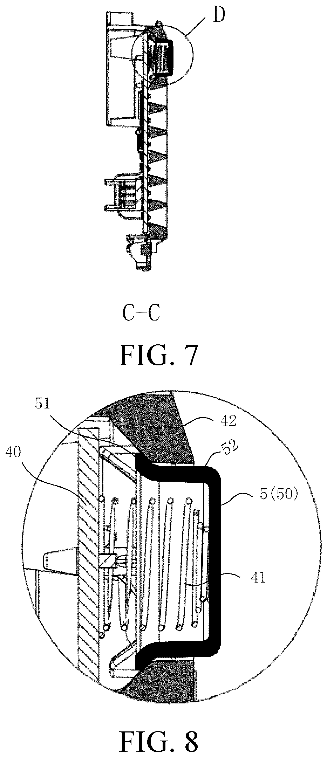

FIG. 6 to FIG. 8 are schematic diagrams of components of the touch control module 4 after fitting. FIG. 8 is an enlarged sectional view in which the isolation members 5 are fitted to the positioning portions 420. As shown in the figure, the isolation members 5 are fitted to the positioning portions 420, and the elastic conductors 41 can extend into the positioning portions 420 and abut against inner surface of the isolation members 5. In addition, under an action of the elastic conductors 41, the limiting portions 51 of the isolation members 5 abut against the positioning portions 420, to limit the isolation members 5 to the positioning portions 420.

In an embodiment, the isolation members 5, although limited to the positioning portions 420, can move in a direction perpendicular to the front cover plate 2. In this way, after the front cover plate 2 is fitted to the touch control module 4, the isolation members 5 can come into seamless contact with the front cover plate 2 without causing excessive squeeze that damages the front cover plate.

In this embodiment, the support hole structure is provided on the touch control module, the isolation members are embedded therein in a free state, and the isolation members are limited to the support through an elastic compression force of the elastic conductors. In this solution, the isolation members not only can be limited to the support without separation, but also can elastically expand and contract in an axial direction of the positioning portions within a specific range.

In an embodiment, the isolation members 5 may have a plurality of configurations enabling the isolation members to be limited to the positioning portions 420.

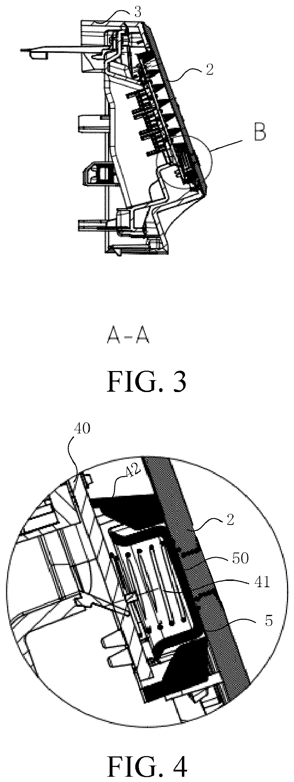

As shown in FIG. 4 and FIG. 8, the isolation members 5 may include isolation portions 50. The isolation portions 50 are substantially parallel to the front cover plate 2. The isolation members further include walls 52 arranged on the isolation portions 50 and extending in an axial direction of the elastic conductors 41. The limiting portions 51 can extend radially outwards from the walls 52.

Preferably, the isolation members 5 may be constructed in the shape of a hat, and the limiting portions 51 are of a brim structure extending radially outwards from edges of the isolation members 5.

The walls 52 of the isolation members 5 may be peripheral walls arranged on the isolation portions 50. The peripheral walls may surround the elastic conductors 41 in a circumferential direction. The walls may be constructed to include walls distributed on the isolation portions 50 at intervals. The limiting portions 51 may include a plurality of protrusions, and the protrusions are distributed on the walls 52.

The isolation members 5 may alternatively be constructed to include a plurality of claw portions distributed on the isolation portions 50. The limiting portions 51 are constructed as structures extending radially outwards from end portions of the claw portions.

The foregoing epitaxial structure, the brim structure, and the protrusion structures can provide a limiting function. For example, since the elastic conductors 41 abut against the isolation members 5, the isolation members are limited to the positioning portions 420 by the limiting structures, thereby preventing the isolation members from being separated from the positioning portions.

In an embodiment, the support 42 includes a surface facing the front cover plate 2. After the circuit module 40 is fitted to the support 42, under an action of the elastic conductors 41, the isolation members 5 can at least partially extend out of the surface by a specific height. Preferably, the height is 2 mm. In this way, the protruding height enables a protruding surface to be in full contact with the front cover plate after the touch control module 4 is fitted to the front cover plate, thereby ensuring seamless contact. In addition, the isolation members are prevented from generating excessive squeeze that damages the front cover plate.

In an embodiment, gaps are formed radially between the isolation members 5 and the positioning portions 420. The gaps need to be formed within a proper range, to ensure that the isolation members can move flexibly, and prevent problems that lead to poor contact such as jamming and tilting.

In an embodiment, the isolation members 5 are made of plastic, and a thickness of the isolation members in an axial direction is in a range of 0.7 mm to 1.0 mm. Since a principle of the touch keys is to detect a capacitance change in a region when a user touches the keys, to realize effective touch of the touch keys, the thickness of the isolation members arranged between the front cover plate and the elastic conductors cannot be excessively large. This preferred embodiment can meet strength requirements on the isolation members while ensuring that a corresponding touch signal can be detected by the touch key.

FIG. 2 to FIG. 4 are schematic diagrams of the front cover plate and the touch control module after fitting. In an actual fitting process, the assembly of the touch control module 4 and the front cover plate 2 may be arranged on the supporting portion 3. Since the isolation members can at least partially extend out of a surface of the support by a specific height under the support of the elastic conductors, outer surfaces of the isolation members can abut against the front cover plate, thereby limiting the isolation members to the positioning portions. As shown in FIG. 4, after the front cover plate is fitted to the touch control module 4, the isolation members are squeezed by the front cover plate, and therefore retract towards the circuit module by a stroke. An additional isolation member structure is added between the elastic conductors and the front cover plate, and a stroke and a position thereof are limited by using the support, so that the fitted structure is more stable. In addition, it is ensured that the isolation members can keep close contact to provide a trigger function.
In this embodiment, the isolation members are embedded in the positioning portions in a free state by using the elastic conductor. Therefore, when the touch control module is subsequently fitted to the front cover plate, the isolation members can be maintained in close contact with the front cover plate, without affecting detection sensitivity of a touch key.

## Claims

1. A touch control panel, **characterized by** comprising:
a front cover plate (2), provided with a main body portion (20), wherein the main body portion (20) is provided with touch key regions (21);
a touch control module (4), comprising a circuit module (40) and a support (42) located between the front cover plate (2) and the circuit module (40), wherein a side of the circuit module (40) close to the front cover plate (2) is provided with elastic conductors (41), the elastic conductors (41) correspond to the touch key regions (21), and the touch control module (4) further comprises isolation members (5),
wherein
the support (42) is provided with positioning portions (420) corresponding to the touch key regions (21), the isolation members (5) are arranged on the positioning portions (420), and the elastic conductors (41) at least partially extend into the positioning portions (420) and abut against inner surfaces of the isolation members (5), so that outer surfaces of the isolation members (5) abut against the front cover plate (2) to limit the isolation members (5) to the positioning portions (420).

2. The touch control panel according to 1, **characterized in that** the positioning portions (420) are of a through hole structure formed on the support (42).

3. The touch control panel according to 1 or 2, **characterized in that** the isolation members (5) are movably arranged on the positioning portions (420) in a direction perpendicular to the front cover plate (2).

4. The touch control panel according to any of the preceding claims, **characterized in that** the isolation members (5) comprise limiting portions (51), and when the circuit module (40) is fitted to the support (42), the limiting portions (51) abut against edges of the positioning portions (420) under an action of the elastic conductors (41).

5. The touch control panel according to 4, **characterized in that** the isolation members (5) further comprise walls (52) extending in an axial direction of the elastic conductors (41), and the limiting portions (51) extend radially outwards from the walls (52).

6. The touch control panel according to claims 4 or 5, **characterized in that** the isolation members (5) are formed in the shape of a hat, and the limiting portions (51) are of a brim structure extending radially outwards from edges of the isolation members (5).

7. The touch control panel according to claims 4 to 6, **characterized in that** the limiting portions (51) comprise a plurality of protrusions, and the protrusions are distributed on the walls (52).

8. The touch control panel according to any of the preceding claims, **characterized in that** the support (42) comprises a surface facing the front cover plate (2), and after the circuit module (40) is fitted to the support (42), the isolation members (5) at least partially extend out of the surface by a specific height under an action of the elastic conductors (41).

9. The touch control panel according to claim 8, **characterized in that** the height is 2 mm.

10. The touch control panel according to any of the preceding claims, **characterized in that** gaps are formed radially between the isolation members (5) and the positioning portions (420).

11. The touch control panel according to any of the preceding claims, **characterized in that** a thickness of the isolation members (5) in an axial direction is in a range of 0.7 mm to 1.0 mm.

12. The touch control panel according to any of the preceding claims, **characterized in that** the isolation members (5) are made of plastic.

13. The touch control panel according to any of the preceding claims, **characterized in that** the touch control module (4) further comprises a display film (43), and the support (42) comprises light guide portions (421), wherein the display film (43) is arranged on a side of the support (42) close to a front cover plate (2) and covers the light guide portions (421).

14. The touch control panel according to claim 1, **characterized by** further comprising a supporting portion (3), wherein the touch control module (4) is arranged on the supporting portion (3).

15. A home appliance, **characterized by** comprising the touch control panel according to any one of claims 1 to 14.
